(19) **Europäisches Patentamt / European Patent Office / Office européen des brevets**

(11) **EP 4 624 950 A1**

(12) # EUROPEAN PATENT APPLICATION

(43) Date of publication:
**01.10.2025  Bulletin 2025/40**

(21) Application number: **25166150.0**

(22) Date of filing: **25.03.2025**

(51) International Patent Classification (IPC):
**G01R 31/327** (2006.01)

(52) Cooperative Patent Classification (CPC):
**G01R 31/3278**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **26.03.2024  CN 202410348582
22.04.2024  CN 202410490931**

(71) Applicant: **Shanghai Sigeyuan Intelligent
Technology Co., Ltd
Shanghai 200120 (CN)**

(72) Inventors:
• **QIN,, Yijin
  Shanghai, 200120 (CN)**
• **YIN,, Zhanxiang
  Shanghai, 200120 (CN)**
• **CHANG,, Hao
  Shanghai, 200120 (CN)**

(74) Representative: **Grey, Ian Michael et al
Venner Shipley LLP
200 Aldersgate
London EC1A 4HD (GB)**

(54) **METHOD FOR DETECTING NEUTRAL RELAY**

(57)    Provided is a method for detecting a neutral relay, belonging to the field of inverters. The method for detecting the neutral relay includes: applying a voltage disturbance to the bus neutral point when other neutral relays except a target neutral relay among the at least one series-connected neutral relay are closed; acquiring potential change information of the bus neutral point relative to the grid neutral point within a period during which the voltage disturbance is applied; and determining a sticking state of the target neutral relay based on the potential change information and a target threshold.

## Description

The present application claims priorities to Chinese Patent Application No. 202410348582.6 filed on March 26, 2024 and Chinese Patent Application No. 202410490931.8 filed on April 22, 2024.

## FIELD

The present disclosure relates to the field of inverter technologies, and more particularly, to a method for detecting a neutral relay.

## BACKGROUND

When an optical storage inverter is connected to the grid, a sticking detection needs to be performed on a grid-connected phase relay to ensure that the relay may be off-gird normally when the system is abnormal. In the related art, a common sticking detection is mainly used for performing sticking detection on phase relays, but may not be used for performing an effective sticking detection on neutral relays (i.e. N relays).

## SUMMARY

The present disclosure aims at solving at least one of the technical problems existing in the related art. To this end, the present disclosure provides a method for detecting a neutral relay. A sticking detection is performed on the neutral relay based on a potential change degree of a bus neutral point relative to a grid neutral point, and a detection result has a high accuracy. Therefore, this technical solution has a high detection efficiency and a high universality, and is simple and convenient to implement.

In a first aspect, the present disclosure provides a method for detecting a neutral relay. The method is applied to an inverter circuit. The inverter circuit has a bus neutral point connected to a grid neutral point via at least one series-connected neutral relay. The method includes: applying a voltage disturbance to the bus neutral point when other neutral relays except a target neutral relay among the at least one series-connected neutral relay are closed; acquiring potential change information of the bus neutral point relative to the grid neutral point within a period during which the voltage disturbance is applied; and determining a sticking state of the target neutral relay based on the potential change information and a target threshold.

According to the method for detecting the neutral relay provided by the present disclosure, by applying the voltage disturbance to the bus neutral point, the sticking detection is performed on the neutral relay based on the potential change degree of the bus neutral point relative to the grid neutral point, and the detection result has a high accuracy. Therefore, this technical solution has a high detection efficiency and a high universality, and is simple and convenient to implement.

According to an embodiment of the present disclosure, the applying the voltage disturbance to the bus neutral point includes at least one of: changing a voltage difference between the bus neutral point and a negative bus of the inverter circuit; changing a potential magnitude of the bus neutral point relative to ground; and changing an impedance magnitude of the bus neutral point relative to the ground.

According to an embodiment of the present disclosure, the applying the voltage disturbance to the bus neutral point includes: changing the voltage difference between the bus neutral point and the negative bus of the inverter circuit.

According to an embodiment of the present disclosure, the changing the voltage difference between the bus neutral point and the negative bus of the inverter circuit includes: adjusting a balancing bridge circuit in the inverter circuit to change the voltage difference between the bus neutral point and the negative bus of the inverter circuit.

According to an embodiment of the present disclosure, the adjusting the balancing bridge circuit in the inverter circuit includes: adjusting the voltage difference to a first value by adjusting the balancing bridge circuit in the inverter circuit at a first moment; and adjusting the voltage difference to a second value by adjusting the balancing bridge circuit in the inverter circuit at a second moment, the second moment being later than the first moment.

According to an embodiment of the present disclosure, the acquiring the potential change information of the bus neutral point relative to the grid neutral point within the period during which the voltage disturbance is applied includes: acquiring a first voltage of the bus neutral point relative to the grid neutral point subsequent to the adjusting the voltage difference to the first value; acquiring a second voltage of the bus neutral point relative to the grid neutral point subsequent to the adjusting the voltage difference to the second value; and determining the potential change information based on a difference between the first voltage and the second voltage.

According to an embodiment of the present disclosure, the determining the sticking state of the target neutral relay based on the potential change information and the target threshold includes: determining that the target neutral relay is not stuck when the potential change information is greater than the target threshold; and determining that the target neutral relay is stuck when the potential change information is smaller than or equal to the target threshold.

According to an embodiment of the present disclosure, the applying the voltage disturbance to the bus neutral point when the other neutral relays except the target neutral relay among the at least one series-connected neutral relay are closed includes: applying the voltage disturbance to the bus neutral point when the inverter circuit is not grid-connected and when the other neutral relays except the target neutral relay among the at least one series-connected neutral relay are closed.

In a second aspect, the present disclosure provides an inverter detection circuit based on the method for detecting the neutral relay according to the first aspect. The inverter detection circuit includes: a voltage disturbance module connected to the inverter circuit and configured to apply the voltage disturbance to the bus neutral point of the inverter circuit; and a processing module configured to determine the sticking state of the target neutral relay based on the potential change information of the bus neutral point relative to the grid neutral point.

According to the inverter detection circuit disclosed by the present disclosure, by applying the voltage disturbance to the bus neutral point, the sticking detection is performed on the neutral relay based on the potential change degree of the bus neutral point relative to the grid neutral point, and the detection result has a high accuracy. Therefore, this technical solution has a high detection efficiency and a high universality, and is simple and convenient to implement.

In a third aspect, the present disclosure provides an electronic device. The electronic device includes a memory, a processor, and a computer program stored in the memory and executable on the processor. The processor, when executing the computer program, implements the method for detecting the neutral relay according to the first aspect.

In a fourth aspect, the present disclosure provides a non-transitory computer-readable storage medium having a computer program stored thereon. A processor, when executing the computer program, implements the method for detecting the neutral relay according to the first aspect.

In a fifth aspect, the present disclosure provides a computer program product including a computer program. A processor, when executing the computer program, implements the method for detecting the neutral relay according to the first aspect.

The above one or more technical solutions in the embodiments of the present disclosure have at least one of the following technical effects. By applying the voltage disturbance to the bus neutral point, the sticking detection is performed on the neutral relay based on the potential change degree of the bus neutral point relative to the grid neutral point, and the detection result has a high accuracy. Therefore, this technical solution has a high detection efficiency and a high universality, and is simple and convenient to implement.

Further, this technical solution has a high flexibility and a high universality, and is easy to implement, which helps to reduce the disturbance cost.

Additional aspects and advantages of the present disclosure will be given at least in part in the following description, or will become apparent at least in part from the following description, or may be learned from practicing of the present disclosure.

## BRIEF DESCRIPTION OF THE DRAWINGS

FIG. 1 is a schematic flowchart of a method for detecting a neutral relay according to an embodiment of the present disclosure.

FIG. 2 is a schematic structural diagram of a detection circuit of a neutral relay according to an embodiment of the present disclosure.

FIG. 3 is a schematic structural diagram of a detection circuit of a neutral relay according to an embodiment of the present disclosure.

FIG. 4 is a schematic structural diagram of a detection circuit of a neutral relay according to an embodiment of the present disclosure.

FIG. 5 is a schematic diagram of results of a method for detecting a neutral relay according to an embodiment of the present disclosure.

FIG. 6 is a schematic diagram of results of a method for detecting a neutral relay according to an embodiment of the present disclosure.

FIG. 7 is a schematic structural diagram of a device for detecting a neutral relay according to an embodiment of the present disclosure.

FIG. 8 is a schematic structural diagram of an electronic device according to an embodiment of the present disclosure.

FIG. 9 is a schematic flowchart of a method for detecting a neutral relay according to an embodiment of the present disclosure.

FIG. 10 is a schematic structural diagram of an inverter circuit according to an embodiment of the present disclosure.

FIG. 11 is a schematic structural diagram of an inverter circuit according to an embodiment of the present disclosure.

FIG. 12 is a schematic structural diagram of the inverter circuit according to an embodiment of the present disclosure.

FIG. 13 is a schematic diagram of results of a method for detecting a neutral relay according to an embodiment of the present disclosure.

FIG. 14 is a schematic diagram of results of a method for detecting a neutral relay according to an embodiment of the present disclosure.

FIG. 15 is a schematic diagram of the results of a method for detecting a neutral relay according to an embodiment of the present disclosure.

FIG. 16 is a schematic structural diagram of a device for detecting a neutral relay according to an embodiment of the present disclosure.

FIG. 17 is a schematic structural diagram of an electronic device according to an embodiment of the present disclosure.

FIG. 18 is a schematic structural diagram of an inverter circuit according to an embodiment of the present disclosure.

FIG. 19 is a schematic diagram of the results of a method for detecting a neutral relay according to an embodiment of the present disclosure.

FIG. 20 is a schematic diagram of the results of a method for detecting a neutral relay according to an embodiment of the present disclosure.

FIG. 21 is a schematic structural diagram of an inverter circuit according to an embodiment of the present disclosure.

FIG. 22 is a schematic diagram of results of a method for detecting a neutral relay according to an embodiment of the present disclosure.

FIG. 23 is a schematic diagram of results of a method for detecting a neutral relay according to an embodiment of the present disclosure.

FIG. 24 is a partial schematic diagram of a bus capacitor of a detection circuit of a neutral relay according to an embodiment of the present disclosure.

FIG. 25 is a schematic structural diagram of an inverter circuit according to an embodiment of the present disclosure.

FIG. 26 is a schematic structural diagram of an inverter circuit according to an embodiment of the present disclosure.

## DETAILED DESCRIPTION OF THE EMBODIMENTS

Technical solutions of the embodiments of the present disclosure will be clearly described below in conjunction with the accompanying drawings in the present disclosure. Obviously, the embodiments described below are only part of the embodiments of the present disclosure and are not all the embodiments of the present disclosure. Based on the embodiments of the present disclosure, other embodiments obtained by those skilled in the art are within the protection scope of the present disclosure.

Terms such as "first", "second" in the description and the claims of the present disclosure are used to distinguish similar objects, rather than to describe a particular order or sequence. It should be understood that data used in this way may be interchanged with each other under appropriate circumstances, such that the embodiments of the present disclosure may be implemented in a sequence other than those illustrated or described in the present disclosure. Objects distinguished by "first" and "second" are usually of one type, and the number of the objects is not limited. For example, the number of a first object may be one or more. In addition, "and/or" in the description and the claims indicates at least one of the objects connected by "and/or", and the character "/" generally indicates an "or" relationship between the objects associated by "/".

A method for detecting a neutral relay, a device for detecting a neutral relay, an electronic device, and a readable storage medium according to the embodiments of the present disclosure are described in detail below with reference to the accompanying drawings through specific embodiments and application scenarios thereof.

The method for detecting the neutral relay may be applied to a terminal, and may be implemented by a hardware or a software in the terminal.

In the method for detecting the neutral relay according to the embodiments of the present disclosure, an implementing subject of the method for detecting the neutral relay may be an inverter detection circuit. The method for detecting the neutral relay according to the embodiments of the present disclosure is described below by taking the inverter detection circuit as the implementing subject.

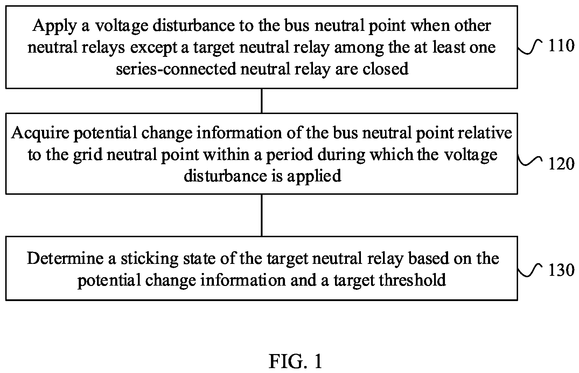

As shown in FIG. 1, the method for detecting the neutral relay includes operations at blocks 110, 120, and 130.

The method for detecting the neutral relay is applied to an inverter circuit.

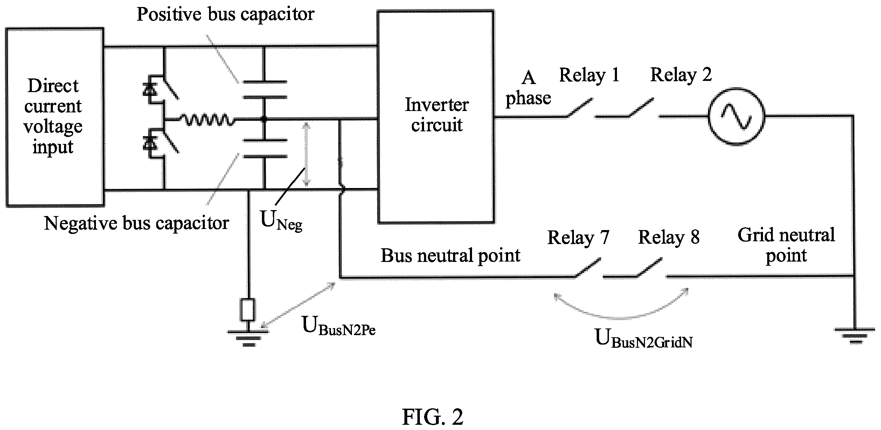

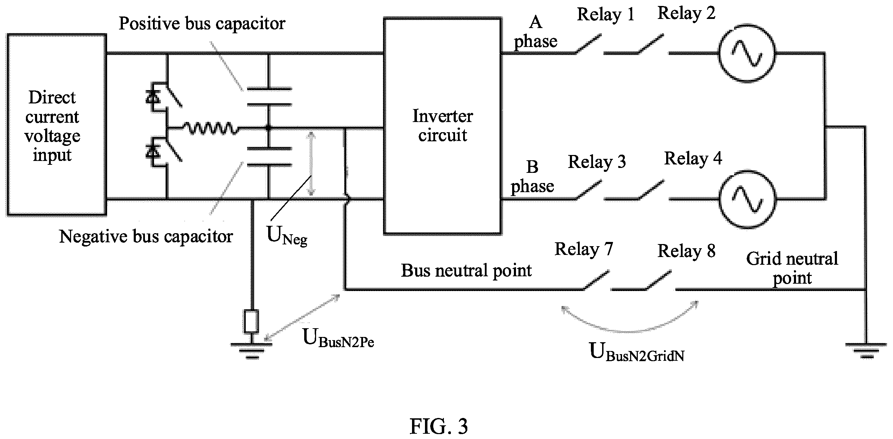

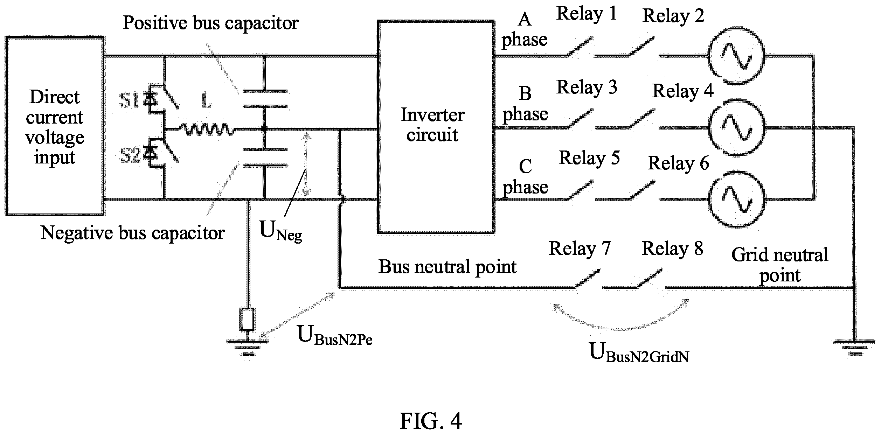

As shown in FIG. 2 to FIG. 4, the inverter circuit may be a three-level inverter circuit, including a single-phase three-level inverter as shown in FIG. 2, a two-phase three-level inverter as shown in FIG. 3, and a three-phase three-level inverter as shown in FIG. 4.

With continued reference to FIG. 2 to FIG. 4, the three-level inverter circuit may include a positive bus capacitor arranged between a positive bus and a neutral line, a negative bus capacitor arranged between a negative bus and the neutral line, an inverter circuit, and multiple grid-connected relays, etc.

The multiple grid-connected relays include a phase relay and a neutral relay.

A bus neutral point of the inverter circuit is connected to a grid neutral point via at least one series-connected neutral relay, as shown in FIG. 4, and the at least one series-connected neutral relay may include a relay 7 and a relay 8.

Each of the positive bus, the negative bus, and the bus neutral point of the inverter circuit has an impedance relative to the ground. The impedance of the negative bus relative to the ground is shown in FIG. 4.

When the neutral relay is stuck, the bus neutral point and the grid neutral point are short-circuited to each other, and the bus neutral point and the grid neutral point have almost no voltage difference.

At block 110, apply a voltage disturbance to the bus neutral point when other neutral relays except a target neutral relay among the at least one series-connected neutral relay are closed.

In this operation, the number of the neutral relays may be one or more, which is not limited in the present disclosure.

The neutral relays are connected in series.

The target neutral relay is the neutral relay on which the sticking detection is to be performed.

The target neutral relay may be any one of all the series-connected neutral relays.

In the actual implementation process, when sticking detection is performed on the target neutral relay, all the other neutral relays except the target neutral relay in the series branch should be closed.

Applying the voltage disturbance to the bus neutral point is used to change a voltage of the bus neutral point.

In some embodiments, the operation at block 110 may include: applying the voltage disturbance to the bus neutral point when the inverter circuit is not grid-connected and when the other neutral relays except the target neutral relay among the at least one series-connected neutral relay are closed

In this embodiment, the inverter circuit is not grid-connected, i.e., a phase inverter remains in an open state.

It should be noted that the sticking detection should be performed on the neutral relay when the neutral relay is not grid-connected.

With continued reference to FIG. 4, taking a case that a sticking state of the relay 7 is detected as an example, relays 1 to 6 may be opened first, while ensuring that relay 8 is closed, and then the voltage disturbance may be applied to the bus neutral point.

In the actual implementation process, the voltage disturbance may be applied to the bus neutral point in a direct or indirect manner, and a specific manner may be selected based on actual conditions, which are not limited herein.

In some embodiments, the applying the voltage disturbance to the bus neutral point may include: changing a voltage difference between the bus neutral point and a negative bus of the inverter circuit.

In this embodiment, the changing the voltage difference between the bus neutral point and the negative bus of the inverter circuit is a manner of indirectly changing a potential magnitude of the bus neutral point.

With continued reference to FIG. 4, the changing the voltage difference between the bus neutral point and the negative bus of the inverter circuit means changing a voltage difference $U_{Neg}$ between two ends of the negative bus capacitor.

At block 120, acquire potential change information of the bus neutral point relative to the grid neutral point within a period during which the voltage disturbance is applied.

In this operation, the potential change information is an actual potential change of the bus neutral point relative to the grid neutral point. The potential change information may include an absolute value of a voltage change magnitude, etc.

In the actual implementation process, a voltage sensor may be arranged between the bus neutral point and the grid neutral point to directly collect a potential difference between the bus neutral point and the grid neutral point, or actual potential values of the bus neutral point relative to the grid neutral point at different collection moments may be collected in an indirect manner, and the potential change information is determined based on the actual potential values corresponding to each collection moment.

Instead of directly providing the voltage sensor between the bus neutral point and the grid neutral point to collect the voltage, the indirect manner indirectly calculates a potential of the bus neutral point relative to the grid neutral point by collecting other voltage information, such as collecting a potential (recorded as $U_{BusN2Pe}$ shown in FIG. 2) of the bus neutral point to the ground via the sensor, and collecting a potential ($U_{GridN2Pe}$)of the grid neutral point relative to the ground via the sensor, and the potential of the bus neutral point relative to the grid neutral point is a difference between the two, i.e.

$$U_{BusN2GridN} = U_{BusN2Pe} - U_{GridN2Pe}.$$

Apparently, in other embodiments, other realizable indirect manners may also be adopted, and the present disclosure is not limited herein.

At block 130, determine a sticking state of the target neutral relay based on the potential change information and a target threshold.

In this operation, the potential change information may include the absolute value of the voltage change magnitude, etc.

The target threshold may be determined based on user-defined, or it may be automatically determined by a system based on historical data, and the present disclosure is not limited herein.

The target threshold is used to determine a potential change degree. When the potential change information is greater than the target threshold, it may be approximately considered that the potential change degree is large. When the potential change information is smaller than or equal to the target threshold, it may be approximately considered that the potential change degree is small or even no change occurs in the potential.

The sticking state includes stuck or not stuck.

It may be understood that, with continued reference to FIG. 4, when the neutral relay is stuck, such as when the relay 7 is stuck, the bus neutral point is short-circuited to the grid neutral point subsequent to the relay 8 being closed. Subsequent to the voltage disturbance being applied to the bus neutral point, the potential of the bus neutral point relative to the grid neutral point will not change significantly.

In some embodiments, the operation at block 130 may include: determining that the target neutral relay is not stuck when the potential change information is greater than the target threshold; and determining that the target neutral relay is stuck when the potential change information is smaller than or equal to the target threshold.

In this embodiment, when the potential change information is smaller than or equal to the target threshold, it is approximately considered that the potential change degree is small or even no change occurs in the potential. In this case, it may be considered that the bus neutral point is short-circuited to the grid neutral point, thereby determining that the target neutral relay is stuck.

When the potential change information is greater than the target threshold, it is considered that the potential change degree is large. In this case, it may be considered that the bus neutral point is not short-circuited to the grid neutral point, thereby determining that the target neutral relay is not stuck.

In the present disclosure, by applying the voltage disturbance to the bus neutral point, the sticking detection is performed on the neutral relay based on the potential change degree of the bus neutral point relative to the grid neutral point, thereby quickly and accurately determining whether a sticking occurs in the target neutral relay. This technical solution is simple and convenient to implement, and has a high detection efficiency. In addition, the technical solution is suitable for performing the sticking detection on any neutral relay in any three-level inverter circuit, and has a high universality.

According to the method for detecting the neutral relay provided by the embodiments of the present disclosure, by applying the voltage disturbance to the bus neutral point, the sticking detection is performed on the neutral relay based on the potential change degree of the bus neutral point relative to the grid neutral point, and the detection result has a high accuracy. Therefore, this technical solution has a high detection efficiency and a high universality, and is simple and convenient to implement.

A specific implementation of applying the voltage disturbance to the bus neutral point will be described below.

The voltage difference between the bus neutral point and the negative bus of the inverter circuit is changed.

With continued reference to FIG. 4, in some embodiments, the changing voltage difference between the bus neutral point and the negative bus of the inverter circuit may include: adjusting a balancing bridge circuit in the inverter circuit to change the voltage difference between the bus neutral point and the negative bus of the inverter circuit.

In this embodiment, the balancing bridge circuit may be configured in the inverter circuit. As shown in FIG. 4, the balancing bridge circuit is connected between the positive bus and the negative bus of the inverter circuit.

The balancing bridge circuit includes a first switching tube S1 and a second switching tube S2 connected in series. A point between the first switching tube S1 and the second switching tube S2 is connected to the bus neutral point via a first inductor L.

By adjusting the balancing bridge circuit, the voltage difference between the two ends of the negative bus capacitor may be changed, that is, the voltage difference between the bus neutral point and the negative bus of the inverter circuit may be changed.

In some embodiments, the adjusting the balancing bridge circuit in the inverter circuit may include: adjusting the voltage difference to a first value by adjusting the balancing bridge circuit in the inverter circuit at a first moment; and adjusting the voltage difference to a second value by adjusting the balancing bridge circuit in the inverter circuit at a second moment, the second moment being later than the first moment.

In this embodiment, the first moment and the second moment may be any moment, and the second moment is a moment later than the first moment.

In some embodiments, the operation at block 120 may include: acquiring a first voltage of the bus neutral point relative to the grid neutral point subsequent to the adjusting the voltage difference to the first value; acquiring a second voltage of the bus neutral point relative to the grid neutral point subsequent to the adjusting the voltage difference to the second value; and determining the potential change information based on a difference between the first voltage and the second voltage.

In this embodiment, taking a sticking detection on the neutral relay 8 as an example, as shown in FIG. 4, the method for detecting the neutral relay includes: controlling the relay 7 to be closed; setting an initial voltage value of the bus neutral point relative to the negative bus as $U_{Neg0}$; at the first moment, i.e. t1 moment, controlling a voltage change amount $U_{Neg1}$ of the bus neutral point relative to the negative bus via the balancing bridge circuit to measure a voltage of the bus neutral point relative to the grid neutral point, denoted as $U_{BusN2GridN1}$; at the second moment, i.e. t2 moment, controlling a voltage change amount $U_{Neg2}$ of the bus neutral point relative to the negative bus via the balancing bridge circuit to measure a voltage of the bus neutral point relative to the grid neutral point, denoted as $U_{BusN2GridN2}$; calculating a voltage change amount of the bus neutral point relative to the grid neutral point, i.e. $U_{BusN2GridN} = |U_{BusN2GridN2} - U_{BusN2GridN1}|$; when $U_{BusN2GridN}$ is greater than the target threshold $U_{Thres}$, determining that the neutral relay 8 is not stuck; and when $U_{BusN2GridN}$ is smaller than the target threshold $U_{Thres}$, determining that the neutral relay 8 is stuck.

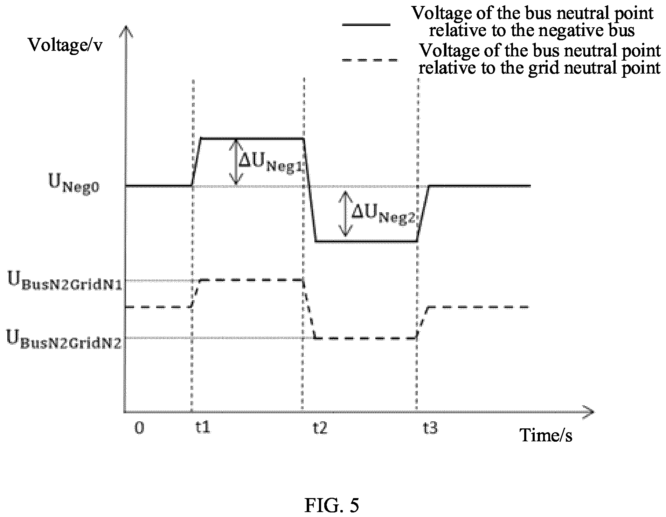

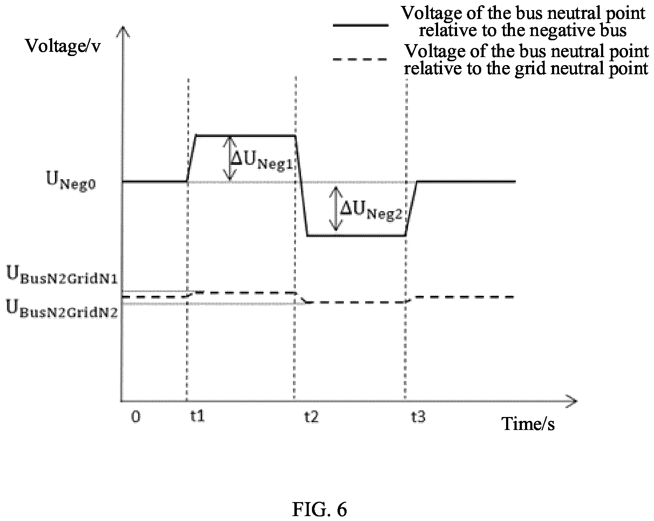

When the relay 8 is not stuck, the potential change information of the bus neutral point relative to the negative bus and the potential change information of the bus neutral point relative to the grid neutral point are shown in FIG. 5. When the relay 8 is stuck, the potential change information of the bus neutral point relative to the negative bus and the potential change information of the bus neutral point relative to the grid neutral point are shown in FIG. 6.

Apparently, in other embodiments, in addition to a square wave signal disturbance as shown in FIG. 5, other waveform signal disturbances, such as a sine wave signal or a triangular wave signal, may also be used, which is not limited by the present disclosure.

In some embodiments, in response to adjusting the balancing bridge circuit in the inverter circuit to change the voltage difference between the bus neutral point and the negative bus of the inverter circuit, it is also possible to continuously increase the voltage difference between the bus neutral point and the negative bus of the inverter circuit several times based on a certain voltage change amount, or continuously decrease the voltage difference between the bus neutral point and the negative bus of the inverter circuit several times based on a certain voltage change amount.

In some embodiments, the voltage difference between the bus neutral point and the negative bus of the inverter circuit may be changed once based on a certain voltage change amount, and then the voltage difference between the bus neutral point and the ground measured before and after the change is taken as the potential change information, which is not limited herein by the present disclosure.

In some embodiments, the operation at block 120 may include: acquiring a first voltage of the bus neutral point relative to the grid neutral point subsequent to the adjusting the voltage difference to the first value and when the voltage is stable; acquiring a second voltage of the bus neutral point relative to the grid neutral point subsequent to the adjusting the voltage difference to the second value and when the voltage is stable; and determining the potential change information based on a difference between the first voltage and the second voltage.

In this embodiment, a target fluctuation range within a certain duration may be set to determine whether the voltage is stable. For example, when a fluctuation range of a voltage within a certain duration does not exceed the target fluctuation range, the voltage is considered to be stable. For example, When the voltage does not change by more than 5V within 1s, the voltage is considered to be stable.

Apparently, in other embodiments, the certain duration and the target fluctuation range may further be set to other values, and may be specifically selected based on actual conditions.

By acquiring the first voltage and the second voltage when the voltage is stable, errors may be further reduced, and the accuracy and precision of subsequent detection results may be improved.

The method for detecting the neutral relay according to the embodiments of the present disclosure has a high flexibility and a high universality, and is easy to implement, which helps to reduce disturbance costs.

The embodiments of the present disclosure further provide an inverter detection circuit based on the method for detecting the neutral relay as described in any of the embodiments above.

The inverter detection circuit includes a voltage disturbance module and a processing module.

As shown in FIG. 4, the voltage disturbance module is connected to the inverter circuit.

The voltage disturbance module is configured to apply the voltage disturbance to the bus neutral point of the inverter circuit.

The processing module is electrically connected to the bus neutral point and is configured to determine the sticking state of the target neutral relay based on the potential change information of the bus neutral point relative to the grid neutral point.

The target neutral relay may be any one of the at least one series-connected neutral relay.

The specific detection operations have been described in the above embodiments, and the present disclosure will not be repeated herein.

According to the inverter detection circuit disclosed by the embodiments of the present disclosure, by applying the voltage disturbance to the bus neutral point, the sticking detection is performed on the neutral relay based on the potential change degree of the bus neutral point relative to the grid neutral point, and the detection result has a high accuracy. Therefore, this technical solution has a high detection efficiency and a high universality, and is simple and convenient to implement.

With continued reference to FIG. 4, in some embodiments, the voltage disturbance module may further include the balancing bridge circuit.

In this embodiment, the balancing bridge circuit is connected between the positive bus and the negative bus of the inverter circuit. The balancing bridge circuit includes the first switching tube S1 and the second switching tube S2 connected in series. The point between the first switching tube S1 and the second switching tube S2 is connected to the bus neutral point via the first inductor L.

By adjusting the balancing bridge circuit, the voltage difference between the two ends of the negative bus capacitor may be changed, that is, the voltage difference between the bus neutral point and the negative bus of the inverter circuit may be changed.

The inverter detection circuit according to the embodiments of the present disclosure has a high flexibility and a high universality, and is easy to implement, which is beneficial to reducing disturbance costs.

An implementing subject of the method for detecting the neutral relay according to the embodiments of the present disclosure may be a device for detecting a neutral relay. In the embodiments of the present disclosure, taking a case that the device for detecting the neutral relay implements the method for detecting the neutral relay as an example, the device for detecting the neutral relay is described.

The embodiments of the present disclosure further provide the device for detecting the neutral relay.

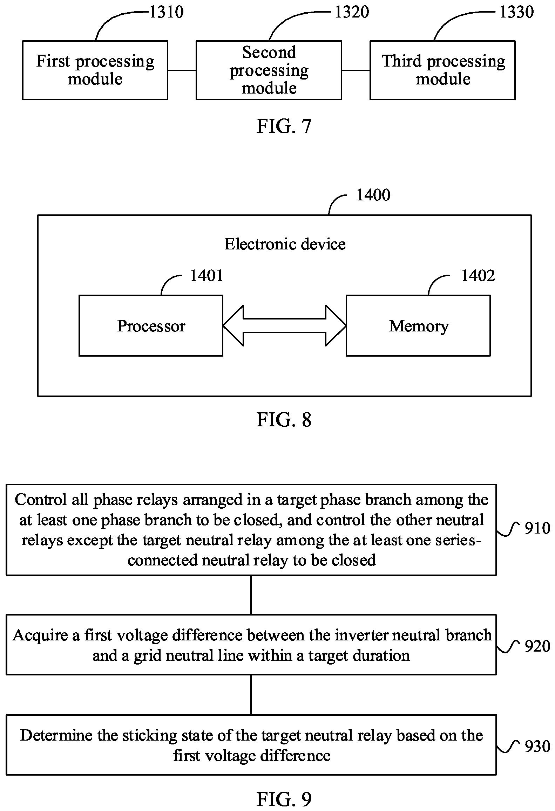

As shown in FIG. 7, the device for detecting the neutral relay is applied to the inverter circuit. The bus neutral point of the inverter circuit is connected to the grid neutral point via at least one series-connected neutral relay. The device for detecting the neutral relay includes a first processing module 1310, a second processing module 1320, and a third processing module 1330.

The first processing module 1310 is configured to apply a voltage disturbance to the bus neutral point when other neutral relays except a target neutral relay among the at least one series-connected neutral relay are closed.

The second processing module 1320 is configured to acquire potential change information of the bus neutral point relative to the grid neutral point within a period during which the voltage disturbance is applied.

The third processing module 1330 is configured to determine a sticking state of the target neutral relay based on the potential change information and a target threshold.

According to the device for detecting the neutral relay disclosed by the embodiments of the present disclosure, by applying the voltage disturbance to the bus neutral point, the sticking detection is performed on the neutral relay based on the potential change degree of the bus neutral point relative to the grid neutral point, and the detection result has a high accuracy. Therefore, this technical solution has a high detection efficiency and a high universality, and is simple and convenient to implement.

In some embodiments, the first processing module 1310 may be further configured to change a voltage difference between the bus neutral point and a negative bus of the inverter circuit.

In some embodiments, the first processing module 1310 may be further configured to adjust a balancing bridge circuit in the inverter circuit to change the voltage difference between the bus neutral point and the negative bus of the inverter circuit.

In some embodiments, the first processing module 1310 may be further configured to: adjust the voltage difference to a first value by adjusting the balancing bridge circuit in the inverter circuit at a first moment; and adjust the voltage difference to a second value by adjusting the balancing bridge circuit in the inverter circuit at a second moment, the second moment being later than the first moment.

In some embodiments, the second processing module 1320 may be further configured to: acquire a first voltage of the bus neutral point relative to the grid neutral point subsequent to said adjusting the voltage difference to the first value; acquire a second voltage of the bus neutral point relative to the grid neutral point subsequent to said adjusting the voltage difference to the second value; and determine the potential change information based on a difference between the first voltage and the second voltage.

In some embodiments, the third processing module 1330 may be further configured to: determine that the target neutral relay is not stuck when the potential change information is greater than the target threshold; and determine that the target neutral relay is stuck when the potential change information is smaller than or equal to the target threshold.

In some embodiments, the first processing module 1310 may be further configured to: apply the voltage disturbance to the bus neutral point when the inverter circuit is not grid-connected and when the other neutral relays except the target neutral relay among the at least one series-connected neutral relay are closed.

The device for detecting the neutral relay in the embodiments of the present disclosure may be an electronic device, or a component in an electronic device, such as an integrated circuit or a chip. The electronic device may be a terminal or other device other than the terminal. For example, the electronic device may be a mobile phone, a tablet computer, a notebook computer, a handheld computer, a vehicle-mounted electronic device, a Mobile Internet Device (MID), augmented reality (AR)/virtual reality (VR) devices, a robot, a wearable device, an ultra-mobile personal computer (UMPC), a netbook or a personal digital assistant (PDA), etc., and may also be a server, a Network Attached Storage (NAS), a personal computer (PC), a television (TV), a teller machine, or a self-service machine, etc., which is not specifically limited in the embodiments of the present disclosure.

The device for detecting the neutral relay in the embodiments of the present disclosure may be a device having an operating system. The operating system may be an Android operating system, an IOS operating system, or other possible operating systems, which is not specifically limited in the embodiments of the present disclosure.

The device for detecting the neutral relay according to the embodiments of the present disclosure is capable of implementing various processes implemented in method embodiments of FIG. 1 to FIG. 6, which will not be described herein to avoid repetition.

In some embodiments, as shown in FIG. 8, the embodiments of the present disclosure further provide an electronic device 1400. The electronic device 1400 includes a processor 1401, a memory 1402, and a computer program stored in the memory 1402 and executable on the processor 1401. The processor 1401, when executing the computer program, implements various processes of the embodiments of the method for detecting the neutral relay described above, and is capable of achieving the same technical results, which will not be described herein to avoid repetition.

It should be noted that the electronic device in the embodiments of the present disclosure includes a mobile electronic device and a non-mobile electronic device described above.

The embodiments of the present disclosure further provide a non-transitory computer-readable storage medium. The non-transitory computer-readable storage medium has a computer program stored thereon. A processor, when executing the computer program, implements various processes of the embodiments of the method for detecting the neutral relay described above, and is capable of achieving the same technical results, which will not be described herein to avoid repetition.

The processor is the processor in the electronic device described in the above embodiments. The readable storage medium includes a computer-readable storage medium, such as a computer read-only memory (ROM), a random access memory (RAM), a magnetic disk, or an optical disk.

The embodiments of the present disclosure further provide a computer program product including a computer program. A processor, when executing the computer program, implements the method for detecting the neutral relay described above.

The processor is the processor in the electronic device described in the above embodiments. The readable storage medium includes a computer-readable storage medium, such as a computer read-only memory (ROM), a random access memory (RAM), a magnetic disk, or an optical disk.

The embodiments of the present disclosure further provide a chip. The chip includes a processor and a communication interface. The communication interface is coupled with the processor, and the processor is configured to run programs or instructions to implement various processes of the embodiments of the method for detecting the neutral relay, and is capable of achieving the same technical results, which will not be described herein to avoid repetition.

It should be understood that the chip mentioned in the embodiments of the present disclosure may further be referred to as a system-level chip, a system chip, a chip system, or a system-on-chip chip.

When an optical storage inverter is connected to the grid, a sticking detection needs to be performed on a grid-connected phase relay to ensure that the relay may be off-gird normally when the system is abnormal. In the related art, a common sticking detection is mainly used for performing sticking detection on phase relays, but may not be used for performing an effective sticking detection on N relays (i.e. neutral relays).

A method for detecting a neutral relay, a device for detecting a neutral relay, an electronic device, and a readable storage medium according to the embodiments of the present disclosure are described in detail below with reference to the accompanying drawings through specific embodiments and application scenarios thereof.

The method for detecting the neutral relay may be applied to a terminal, and may be implemented by a hardware or a software in the terminal.

The terminal includes, but is not limited to, a mobile phone or a tablet computer. It should also be understood that in some embodiments, the terminal may not be a portable device, but rather a desktop computer or an inverter circuit.

In the method for detecting the neutral relay according to the embodiments of the present disclosure, an implementing subject of the method for detecting the neutral relay may be the electronic device or the inverter circuit; or may be a functional module or functional entity capable of implementing the method for detecting the neutral relay in the electronic device or the inverter circuit. The electronic device mentioned in the embodiments of the present disclosure includes, but is not limited to, a mobile phone, a tablet computer, a computer, a camera, a wearable device, etc. The method for detecting the neutral relay according to the embodiments of the present disclosure is described below by taking the inverter detection circuit as the implementing subject.

It should be noted that the method for detecting the neutral relay is applied to the inverter circuit.

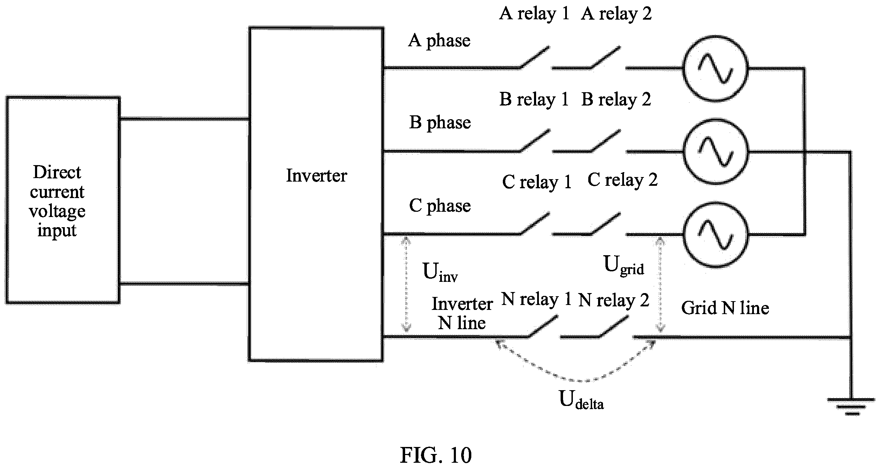

As shown in FIG. 10, the inverter circuit includes at least one phase branch and an inverter neutral branch. The phase branch is provided with at least one series-connected phase relay. The inverter neutral branch is provided with at least one series-connected neutral relay. The inverter is connected to the power grid via the phase branch.

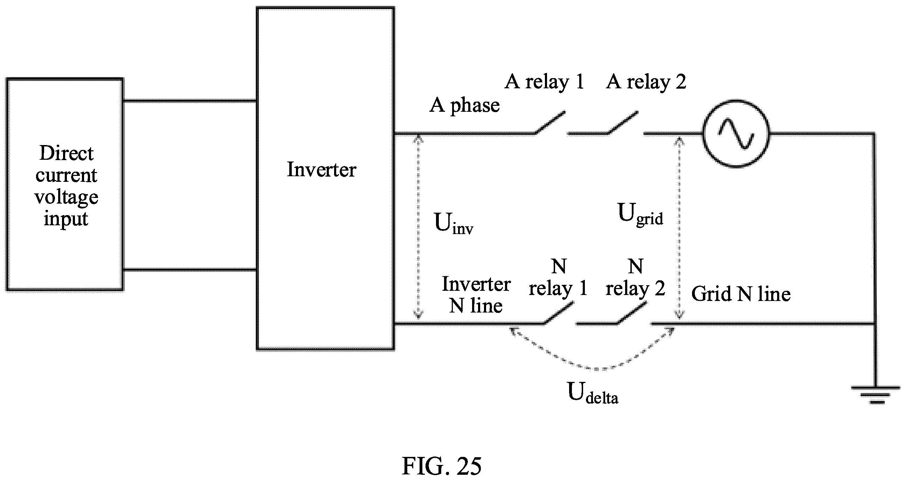

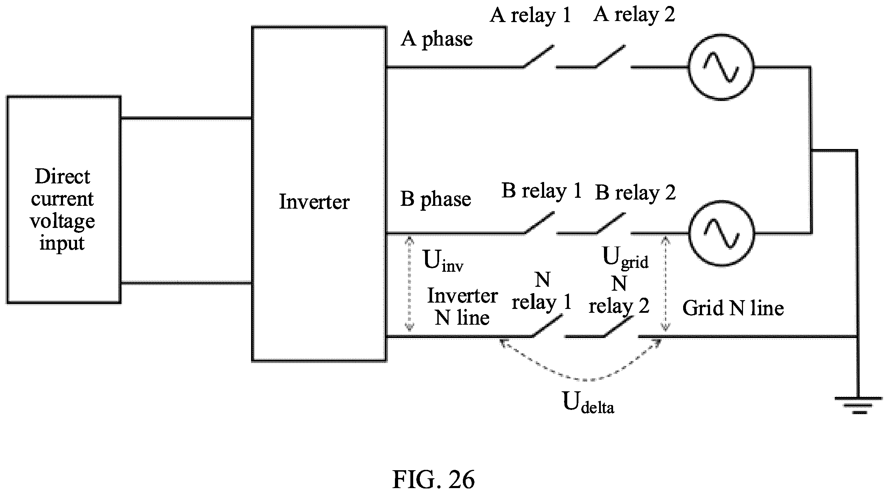

In some embodiments, the inverter circuit may be a single-phase inverter, as shown in FIG. 25. The inverter circuit may further be a multi-phase inverter, as shown in FIG. 26 for a two-phase inverter and as shown in FIG. 10 for a three-phase inverter.

As shown in FIG. 9, the method for detecting the neutral relay includes operations at blocks 910, 920 and 930.

At block 910, control all phase relays arranged in a target phase branch among the at least one phase branch to be closed, and control the other neutral relays except the target neutral relay among the at least one series-connected neutral relay to be closed.

In this operation, the inverter circuit may include a single-phase inverter, a two-phase inverter, and a three-phase inverter, etc.

The target phase branch may be any phase in the inverter circuit.

The target neutral relay may be any neutral relay among all the series-connected neutral relays arranged in the neutral branch, and the sticking detection method for each neutral relay is similar.

During performing the sticking detection on the neutral relay, all phase relays in any one phase branch and other neutral relays except the target neutral relay in the neutral branch in which the target neutral relay is located may be closed, and phase relays of other phase branches may be controlled to be opened.

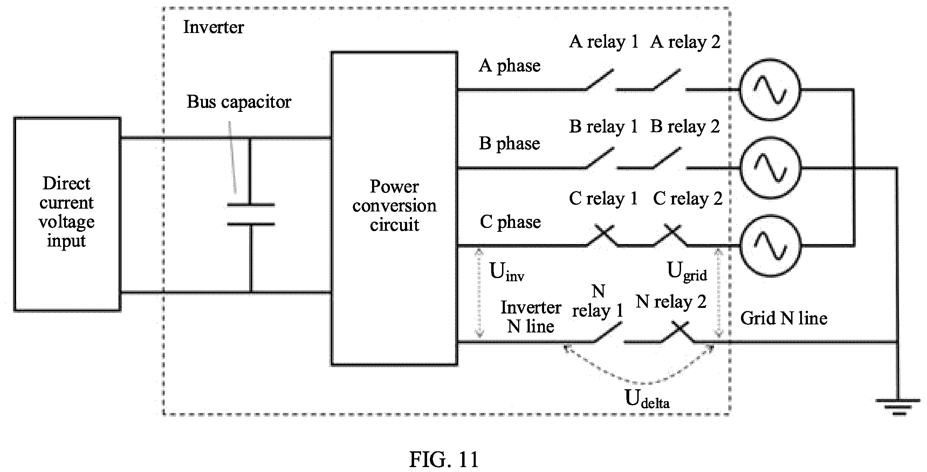

Continuing to take the circuit shown in FIG. 10 as an example, when the target phase branch is a C phase branch and the target neutral relay is an N relay 1, a C relay 1 and a C relay 2 in the C phase branch may be controlled to be closed, an N relay 2 may be controlled to be closed, and an N relay 1 may be controlled to be opened. In addition, an A phase branch and a B phase branch may be controlled to maintain to be opened, i.e., an A relay 1, an A relay 2, a B relay 1, and a B relay 2 may be controlled to maintain to be opened, as shown in FIG. 11.

At block 920, acquire a first voltage difference between the inverter neutral branch and a grid neutral line within a target duration.

In this operation, the target duration may be determined based on user-defined.

The first voltage difference is an actual voltage difference between the inverter neutral branch and the grid neutral line, for example $U_{delta}$ shown in FIG. 10.

The first voltage difference varies over time within the target duration.

A manner of acquiring the first voltage difference will be described in detail below.

In some embodiments, the operation at block 920 may include: obtaining the first voltage difference by performing sampling by a sensor disposed between the inverter neutral branch and the grid neutral line.

In this embodiment, a sensor may be provided in the inverter circuit to collect the voltage in real time to obtain the first voltage difference.

In some embodiments, the operation at block 920 may include: performing a calculation based on an inverter output voltage of the inverter and a grid voltage of the power grid acquired in the target duration.

In this embodiment, with continued reference to FIG. 11, the inverter output voltage is a voltage of an inverter relative to an inverter N line, denoted as $U_{inv}$.

The grid voltage is a voltage of the power grid relative to a grid N line, denoted as $U_{grid}$.

The inverter output voltage $U_{inv}$ and the grid voltage $U_{grid}$ may be acquired, and a difference between the grid voltage $U_{grid}$ and the inverter output voltage $U_{inv}$ at a same moment is calculated to obtain the first voltage difference.

In the actual implementation process, the optimal acquisition manner may be selected based on actual conditions, and the present disclosure is not limited thereto.

In the present disclosure, the manner of acquiring the first voltage difference is flexible and simple to implement.

At block 930, determine the sticking state of the target neutral relay based on the first voltage difference.

In this operation, the sticking state may include stuck or not stuck.

It may be understood that when the target neutral relay is stuck, the series-connected neutral relays form a conductive path, and the difference between the grid voltage $U_{grid}$ and the inverter output voltage $U_{inv}$ is small. When the target neutral relay is not stuck, the series-connected neutral relays form an open circuit, and the difference between the grid voltage $U_{grid}$ and the inverter output voltage $U_{inv}$ is large. The sticking state of the target neutral relay may be determined based on a change condition of the first voltage difference.

In some embodiments, the operation at block 930 may include: calculating a voltage difference effective value corresponding to the first voltage difference based on the first voltage difference; and determining the sticking state of the target neutral relay based on the voltage difference effective value and a second target threshold.

In this embodiment, taking commercial power as an example, the voltage difference effective value may be 0.707 times a peak voltage corresponding to the first voltage difference. The second target threshold is a smaller positive value.

The second target threshold may be determined based on user-defined or determined based on experimental data, which is not limited by the present disclosure.

When the voltage difference effective value is greater than the second target threshold, the voltage difference effective value is considered to be large.

When the voltage difference effective value is smaller than or equal to the second target threshold, the voltage difference effective value may be considered to be small and may be ignored.

In some embodiments, the determining the sticking state of the target neutral relay based on an absolute value of the voltage difference and the second target threshold may include: determining that the target neutral relay is not stuck when the voltage difference effective value is greater than the second target threshold; and determining that the target neutral relay is stuck when the voltage difference effective value is smaller than or equal to the second target threshold.

In this embodiment, when the voltage difference effective value is greater than the second target threshold, it is considered that the voltage difference effective value is large, that is, the difference between the grid voltage $U_{grid}$ and the inverter output voltage $U_{inv}$ is large, and it may be determined that the target neutral relay is not stuck.

When the voltage difference effective value is smaller than or equal to the second target threshold value, it is considered that the voltage difference effective value is small, that is, the difference between the grid voltage $U_{grid}$ and the inverter output voltage $U_{inv}$ is small, and it may be determined that the target neutral relay is stuck.

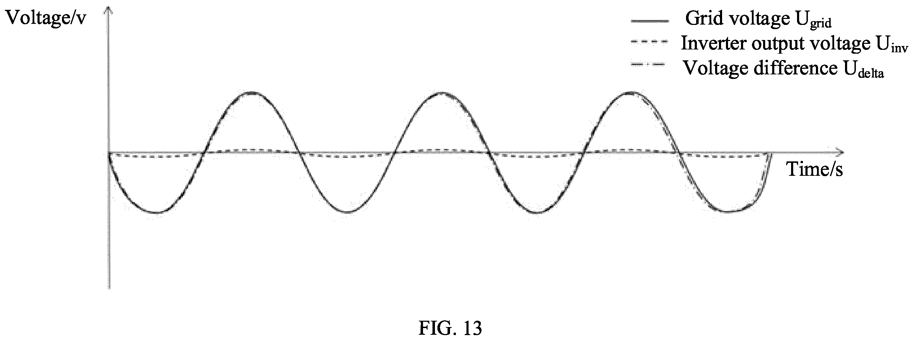

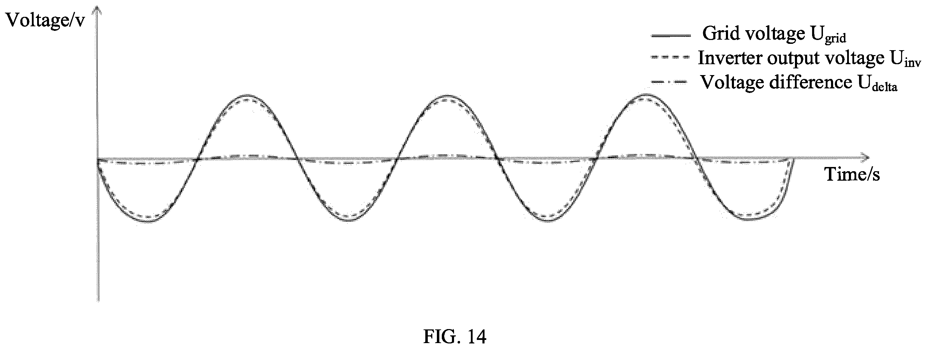

Continuing to take a case, that the target phase branch is the C phase branch and the target neutral relay is the N relay 1, as an example, for a circuit shown in FIG. 11, the grid voltage $U_{grid}$ and the inverter output voltage $U_{inv}$ in the target duration are acquired, and a relationship between the grid voltage $U_{grid}$ and the inverter output voltage $U_{inv}$ over time is shown in FIG. 13 and FIG. 14.

Calculating the difference between the grid voltage $U_{grid}$ and the inverter output voltage $U_{inv}$ may obtain the relationship between the first voltage difference $U_{delta}$ and time, as shown in FIG. 13 and FIG. 14.

An effective value of the first voltage difference $U_{delta}$ shown in FIG. 13 is relatively large, which indicates that the N relay 1 is opened and is not stuck.

The effective value of the first voltage difference $U_{delta}$ shown in FIG. 14 is small, which indicates that the N relay 1 is stuck.

In a research and development process, in the related art, when the sticking detection is performed on the neutral relay, new components generally need to be introduced, which makes a circuit structure complex and increases detection costs.

In the present disclosure, when all phase relays arranged in the target phase branch are controlled to be closed, and the other neutral relays except the target neutral relay among the series-connected neutral relay are controlled to be closed, whether the target neutral relay is stuck or not is detected based on the first voltage difference between the inverter neutral branch and the grid neutral line. Without introducing new components, the circuit structure is simple and convenient to implement, and the detection costs are effectively reduced. In addition, the precise and the accurate of the detection are high.

According to the method for detecting the neutral relay provided by the embodiments of the present disclosure, when all phase relays arranged in the target phase branch are controlled to be closed and the other neutral relays except the target neutral relay among the series-connected neutral relay are controlled to be closed, whether the target neutral relay is stuck or not is detected based on the first voltage difference between the inverter neutral branch and the grid neutral line. The technical solution has a high detection precision and a high accuracy, and is simple and convenient to implement, and has a low detection cost.

In some embodiments, the operation at block 910 may include: controlling all the phase relays arranged in the target phase branch to be closed; adjusting a difference between an inverter output voltage of the inverter circuit and a grid voltage to be smaller than or equal to a first target threshold; and controlling the other neutral relays to be closed.

In this embodiment, the first target threshold is a small positive value.

The difference may be expressed as an absolute value of the difference.

When the difference between the inverter output voltage and the grid voltage is smaller than or equal to the first target threshold, the inverter output voltage may be considered to be approximately equal to the grid voltage.

In the actual implementation process, all phase relays in any one phase branch may be controlled to be closed, and relays arranged in other phase branches and the neutral branch are maintained to be opened. Then the inverter output voltage of the inverter circuit is adjusted to be approximately equal to the grid voltage, and subsequent to the inverter output voltage being equal to the grid voltage, other neutral relays except the target neutral relay in the neutral branch are controlled to be closed.

By performing a synchronous control prior to other neutral relays being closed, a large voltage difference between the inverter output voltage $U_{inv}$ and the grid voltage $U_{grid}$ caused by directly closing other neutral relays subsequent to the phase relay being closed may be avoided, and a voltage impact generated when the target neutral relay is stuck may be avoided, therefore damage of the device may further be avoided.

In some embodiments, the operation at block 920 may include: controlling the inverter circuit to stop outputting voltage; and acquiring the first voltage difference between the inverter neutral branch and the grid neutral line within the target duration.

In this embodiment, subsequent to the synchronous control is completed, i.e., when the phase relay of the target phase branch is closed and the neutral relay is opened, the inverter output voltage is adjusted to be consistent with the grid voltage, and then the other neutral relays except the target neutral relay in the neutral branch are controlled to be closed. For example, when the neutral relay 1 is detected, the neutral relay 2 is closed. In this case, a voltage difference effective value between the inverter N line and the grid N line is small. Even if the neutral relay 1 is stuck, the device will not be damaged due to the voltage impact, and a normal operation of the circuit is effectively protected, thereby prolonging the service life of the circuit.

Then outputting the inverter voltage is stopped, the inverter voltage is no longer actively controlled to be consistent with the grid voltage.

The first voltage difference between the inverter neutral branch and the grid neutral line in the target duration is acquired, and a sticking detection is performed based on the first voltage difference.

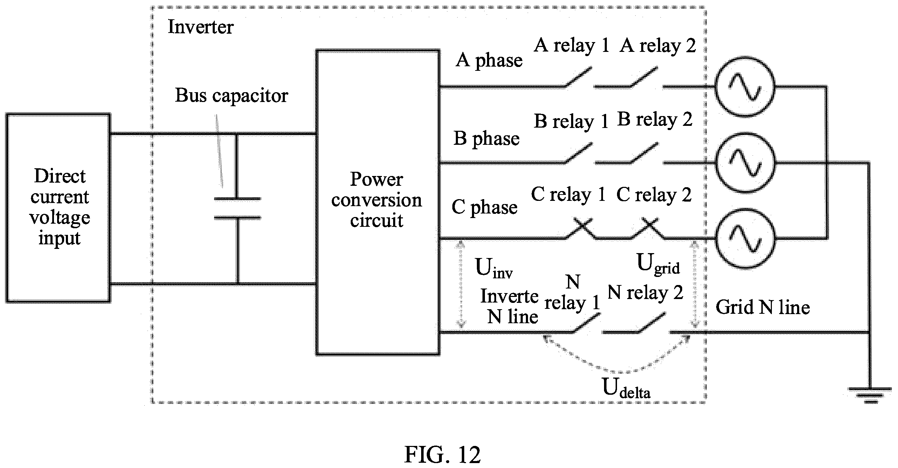

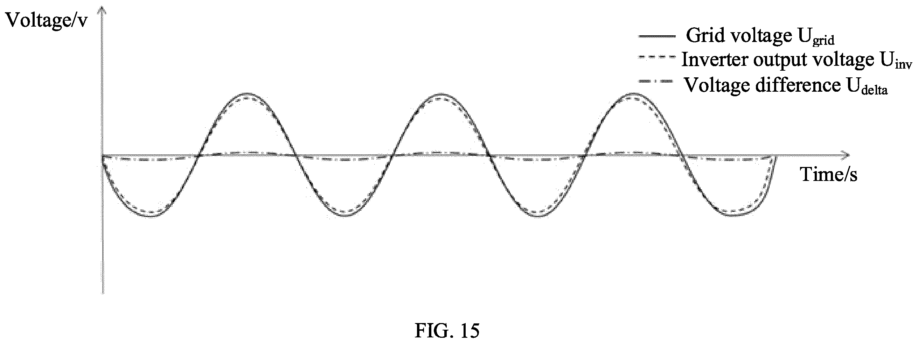

Referring to FIG. 10, when the target phase branch is the C phase branch and the target neutral relay is the N relay 1, the C relay 1 and the C relay 2 in the C phase branch may be controlled to be closed first, and then the N relay 2 is maintained to be opened, as shown in FIG. 12. Next, the synchronous control is performed to control the inverter output voltage $U_{inv}$ (i.e., the voltage of the inverter relative to the inverter N line) to be consistent with the grid voltage $U_{grid}$ (i.e., the voltage of the grid relative to the grid N line), allowing a voltage effective value of the first voltage difference $U_{delta}$ between the inverter N line and the grid N line to be smaller than the first target threshold value. The schematic diagram of the voltage is shown in FIG. 15.

Then, the N relay 2 is controlled to be closed, as shown in FIG. 11, outputting the inverter voltage is stopped to allow the inverter voltage to no longer be actively controlled to be consistent with the grid voltage. The first voltage difference $U_{delta}$ between the inverter neutral branch and the grid neutral line is acquired, and a sticking detection is performed on the N relay 1 based on the first voltage difference $U_{delta}$.

The method for performing the sticking detection on other neutral relays is similar to the method for performing the sticking detection on the N relay 1, which is not described herein in the present disclosure.

According to the method for detecting the neutral relay provided by the embodiments of the present disclosure, the synchronous control is performed prior to controlling other neutral relays except the target neutral relay to be closed. In this way, the voltage difference between the inverter N line and the grid N line is reduced to avoid device damage caused by the voltage impact, and the normal operation of the circuit is effectively protected, thereby improving the detection effect and prolonging the service life of the circuit.

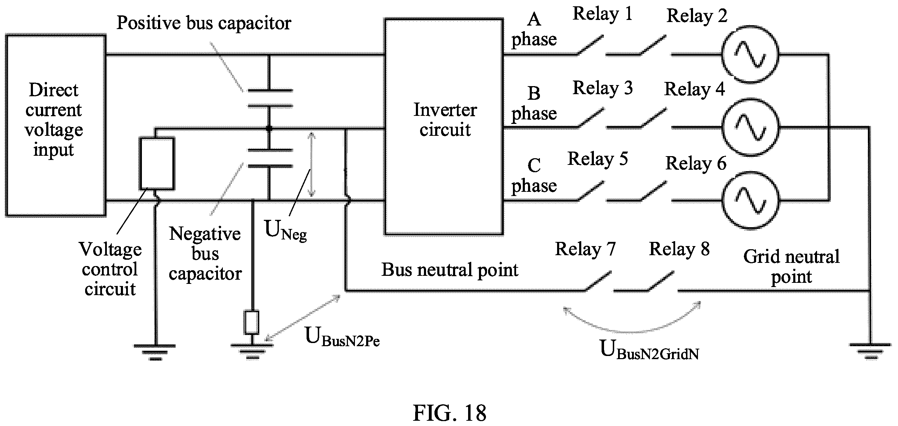

As shown in FIG. 18, in some embodiments, the bus neutral point of the inverter circuit is connected to the grid neutral point via at least one series-connected neutral relay. A voltage control circuit is provided in the inverter circuit. One end of the voltage control circuit is connected to the bus neutral point, and another end of the voltage control circuit is grounded.

Prior to the operation at block 920, the method may further include: controlling the other neutral relays except the target neutral relay among the at least one series-connected neutral relay to be closed, and adjusting an output voltage of the voltage control circuit to change the potential magnitude of the bus neutral point relative to the ground.

In this embodiment, the phase relay should be controlled to maintain to be opened.

The voltage control circuit is configured to apply the voltage disturbance to the bus neutral point to change the potential of the bus neutral point relative to the ground.

The target duration may be a time period from a time point before the voltage disturbance is applied to a time point after the voltage disturbance is applied.

Subsequent to applying the voltage disturbance to the bus neutral point, the operation at block 920 may be performed to acquire the first voltage difference between the inverter neutral branch and the grid neutral line within the time period from a time point before the voltage disturbance is applied to a time point after the voltage disturbance is applied, i.e., to acquire the voltage of the bus neutral point relative to the grid neutral point.

It should be noted that in the actual implementation process, the first voltage difference between the inverter neutral branch and the grid neutral line should be acquired before the voltage disturbance is applied and after the voltage disturbance is applied.

The operation at block 930 may include: determining the potential change information of the bus neutral point relative to the grid neutral point based on the first voltage difference; and determining the sticking state of the target neutral relay based on the potential change information and a third target threshold.

The third target threshold may be determined based on user-defined.

The potential change information refers to the actual potential change of the bus neutral point relative to the grid neutral point within the target duration (i.e. the time period from a time point before the voltage disturbance is applied to a time point after the voltage disturbance is applied).

The potential change information may include an absolute value of the voltage change magnitude, etc.

When the potential change information is smaller than or equal to the third target threshold value, it is approximately considered that the potential change degree is small or even no change occurs in the potential. In this case, it may be considered that the bus neutral point is short-circuited to the grid neutral point, thereby determining that the target neutral relay is stuck.

When the potential change information is greater than the third target threshold, it is considered that the potential change degree is large. In this case, it may be considered that the bus neutral point is not short-circuited to the grid neutral point, thereby determining that the target neutral relay is not stuck.

Next, the sticking detection of the neutral relay 8 will be described as an example. With continued reference to FIG. 18, the relay 7 is controlled to be closed. An initial voltage value of the bus neutral point relative to the ground is set to be $U_{BusN2Pe0}$, and an initial voltage value of the bus neutral point relative to the grid neutral point is set to be $U_{BusN2GridN0}$, i.e., a first voltage difference prior to applying the voltage disturbance is $U_{BusN2GridN0}$. The voltage control circuit is controlled to operate at t1 moment, and the output voltage of the voltage control circuit is set to $U_{BusN2Pe1}$. A voltage $U_{BusN2GridN2}$ of the bus neutral point relative to the grid neutral point is collected at t2 moment, i.e. a first voltage difference subsequent to applying the voltage disturbance is $U_{BusN2GridN2}$. The potential change information of the bus neutral point relative to the grid neutral point is calculated as $U_{BusN2GridN}=|U_{BusN2GridN2}-U_{BusN2GridN0}|$. When the potential change information $U_{BusN2GridN}$ is greater than the third target threshold value $U_{Thres}$, it is determined that the neutral relay 8 is not stuck. When the potential change information $U_{BusN2GridN}$ is smaller than the third target threshold value $U_{Thres}$, it is determined that the neutral relay 8 is stuck.

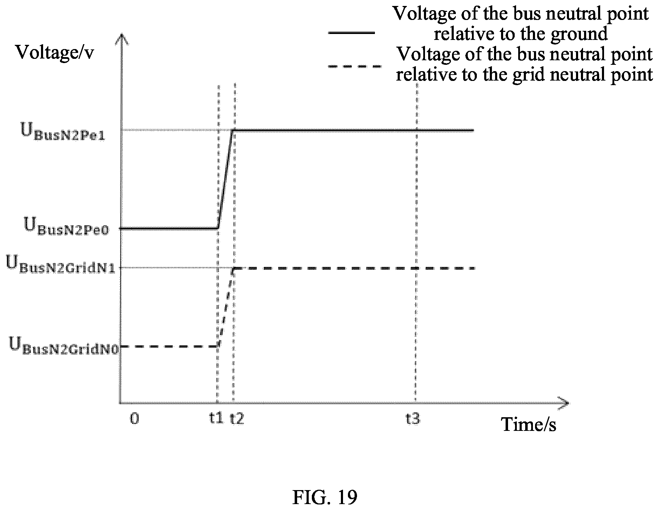

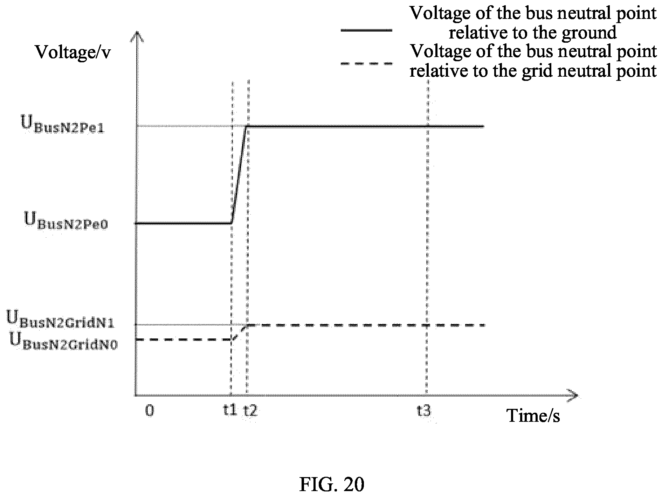

When the relay 8 is not stuck, the potential change information of the bus neutral point relative to the ground and the potential change information of the bus neutral point relative to the grid neutral point are shown in FIG. 19. When the relay 8 is stuck, the potential change information of the bus neutral point relative to the ground and the potential change information of the bus neutral point relative to the grid neutral point are shown in FIG. 20.

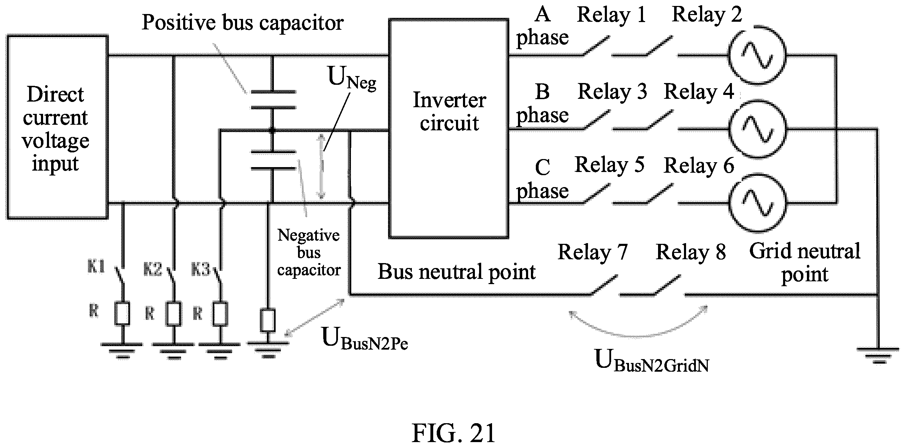

As shown in FIG. 21, in some embodiments, the bus neutral point of the inverter circuit is connected to the grid neutral point via at least one series-connected neutral relay. At least one resistance module is provided in the inverter circuit. The resistance module includes a first switch and at least one first resistor connected in series. The at least one resistance module is arranged between the ground and a target point. The target point includes a positive bus point, the bus neutral point, and a negative bus point of the inverter circuit.

Prior to the operation at block 920, the method may further include: controlling the other neutral relays except the target neutral relay among the at least one series-connected neutral relay to be closed, and adjusting an on-off state of the first switch to change the impedance magnitude of the bus neutral point relative to the ground.

In this embodiment, the phase relay should be controlled to maintain to be closed.

The target point may be one or more of the positive bus point, the bus neutral point, and the negative bus point of the inverter circuit.

For example, as shown in FIG. 21, a first resistance module may be provided between the negative bus point and the ground, a second resistance module may be provided between the positive bus point and the ground, and a third resistance module may be provided between the bus neutral point and the ground.

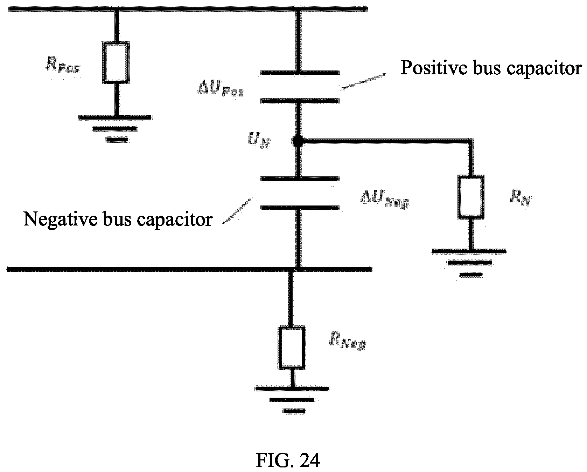

FIG. 24 illustrates a partial schematic diagram of a bus capacitor. As shown in FIG. 24, the positive bus, the negative bus, and the bus neutral point all have impedance relative to the ground, which are respectively $R_{Pos}$, $R_{Neg}$, and $R_N$. A voltage of the bus neutral point relative to the ground is $U_N$. A voltage across the positive bus capacitor is $U_{Pos}$. A voltage across the negative bus capacitor is $U_{Neg}$.

According to the KCL law, a current flowing into the bus neutral point is equal to a current flowing out of the bus neutral point, i.e.

$$\frac{U_N}{R_N} + \frac{U_N + U_{Pos}}{R_{Pos}} = -\frac{U_N - U_{Neg}}{R_{Neg}}$$

Based on the above formula, it may be obtained:

$$U_N = \frac{U_{Neg}R_N R_{Pos} - U_{Pos}R_N R_{Neg}}{R_N R_{Pos} + R_N R_{Neg} + R_{Neg}R_{Pos}}$$

It may be seen that when the positive and negative bus capacitor voltages $U_{Pos}$ and $U_{Neg}$ are determined, the voltage $U_N$ of the bus neutral point relative to the ground is determined by impedances $R_{Pos}$, $R_{Neg}$, and $R_N$ of the positive bus/negative bus/ the bus neutral point relative to the ground. Therefore, the potential of the bus neutral point may be changed by changing these three impedances through an external circuit.

Continuing with the sticking detection of the neutral relay 8 as an example, as shown in FIG. 21, the relay 7 is controlled to be closed. The initial voltage value of the bus neutral point relative to the grid neutral point (i.e. the first voltage difference prior to applying the voltage disturbance) is set to be $U_{BusN2GridN0}$. At t1 moment, any on-off state change or any combination state change of K1/K2/K3 switches in each resistance module is controlled, to change the potential of the bus neutral point relative to the grid neutral point. An actual voltage between the bus neutral point and the grid neutral point collected at t2 moment (i.e., the first voltage difference subsequent to applying the voltage disturbance) is $U_{BusN2GridN1}$. The potential change information of the bus neutral point relative to the grid neutral point may be calculated, i.e. $U_{BusN2GridN} = |U_{BusN2GridN1} - U_{BusN2GridN0}|$. When an actual change amount $U_{BusN2GridN}$ of the voltage of the bus neutral point is greater than the third target threshold $U_{Thres}$, the neutral relay 8 is determined to be not stuck; and when $U_{BusN2GridN}$ is smaller than the third target threshold $U_{Thres}$, the neutral relay 8 is determined to be stuck.

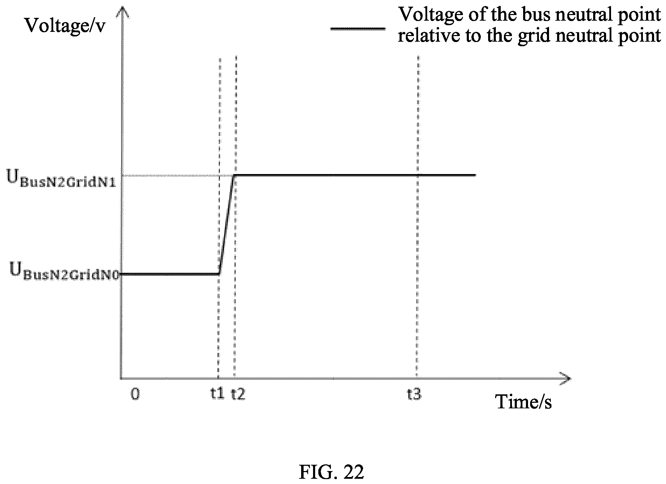

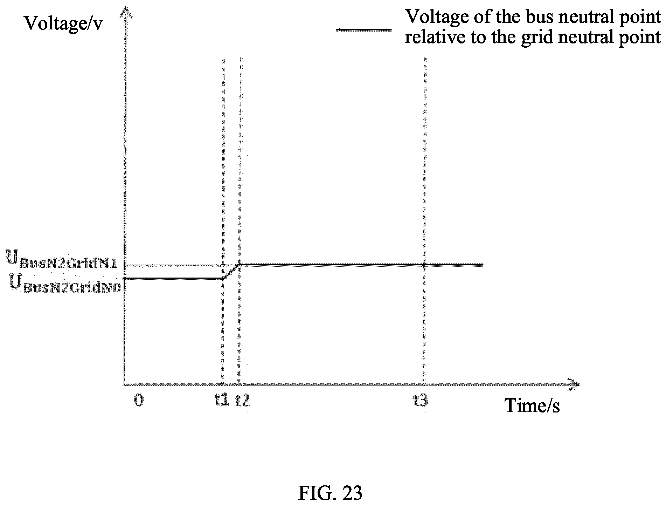

When the relay 8 is not stuck, the potential change information of the bus neutral point relative to the grid neutral point is shown in FIG. 22. When the relay 8 is stuck, the potential change information of the bus neutral point relative to the grid neutral point is shown in FIG. 23.

According to the method for detecting the neutral relay provided by the embodiment of the present disclosure, by applying the voltage disturbance to the bus neutral point, the sticking detection is performed on the neutral relay based on the potential change degree of the bus neutral point relative to the grid neutral point, and the detection result has a high accuracy. Therefore, this technical solution has a high detection efficiency and a high universality, and is simple and convenient to implement.

An implementing subject of the method for detecting the neutral relay according to the embodiments of the present disclosure may be a device for detecting a neutral relay. In the embodiments of the present disclosure, taking a case that the device for detecting the neutral relay implements the method for detecting the neutral relay as an example, the device for detecting the neutral relay is described.

The embodiments of the present disclosure further provide the device for detecting the neutral relay.

The device for detecting the neutral relay is applied to the inverter circuit. The inverter circuit includes at least one phase branch and the inverter neutral branch. The phase branch is provided with at least one series-connected phase relay, and the inverter neutral branch is provided with at least one series-connected neutral relay.

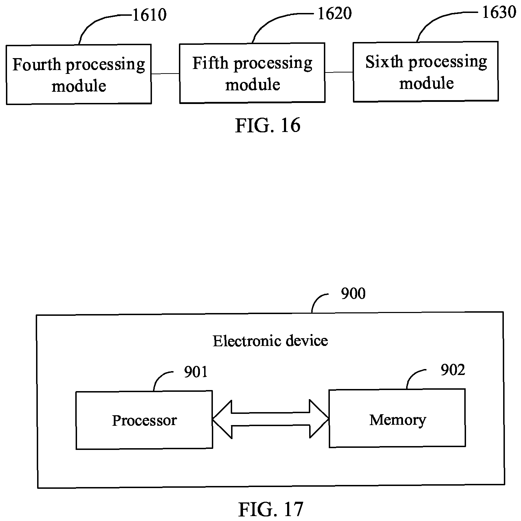

As shown in FIG. 16, the device for detecting the neutral relay includes a fourth processing module 1610, a fifth processing module 1620, and a sixth processing module 1630.

The fourth processing module 1610 is configured to control all phase relays arranged in a target phase branch among the at least one phase branch to be closed, and control the other neutral relays except the target neutral relay among the at least one series-connected neutral relay to be closed.

The fifth processing module 1620 is configured to acquire a first voltage difference between the inverter neutral branch and a grid neutral line within a target duration.

The sixth processing module 1630 is configured to determine the sticking state of the target neutral relay based on the first voltage difference.

According to the device for detecting the neutral relay provided by the embodiments of the present disclosure, when all phase relays arranged in the target phase branch are controlled to be closed and the other neutral relays except the target neutral relay among the series-connected neutral relay are controlled to be closed, whether the target neutral relay is stuck or not is detected based on the first voltage difference between the inverter neutral branch and the grid neutral line. The technical solution has a high detection precision and a high accuracy, and is simple and convenient to implement, and has a low detection cost.

In some embodiments, the fourth processing module 1610 may be further configured to: control all the phase relays arranged in the target phase branch to be closed; adjust a difference between an inverter output voltage of the inverter circuit and a grid voltage to be smaller than or equal to a first target threshold; and control the other neutral relays to be closed.

In some embodiments, the fifth processing module 1620 may be further configured to: control the inverter circuit to stop outputting voltage; and acquire the first voltage difference between the inverter neutral branch and the grid neutral line within the target duration.

In some embodiments, the sixth processing module 1630 may be further configured to: calculate a voltage difference effective value corresponding to the first voltage difference based on the first voltage difference; and determine the sticking state of the target neutral relay based on the voltage difference effective value and a second target threshold.

In some embodiments, the sixth processing module 1630 may be further configured to: determine that the target neutral relay is not stuck when the voltage difference effective value is greater than the second target threshold; and determine that the target neutral relay is stuck when the voltage difference effective value is smaller than or equal to the second target threshold.

In some embodiments, the fifth processing module 1620 may be further configured to: acquire the first voltage difference by performing sampling by a sensor arranged between the inverter neutral branch and the grid neutral line; and/or perform a calculation based on the inverter output voltage of the inverter and the grid voltage of the power grid acquired in the target duration.

In some embodiments, the bus neutral point of the inverter circuit is connected to the grid neutral point via at least one series-connected neutral relay. The voltage control circuit is provided in the inverter circuit. One end of the voltage control circuit is connected to the bus neutral point, and another end of the voltage control circuit is grounded.

The device may further include a seventh processing module configured to, prior to acquiring the first voltage difference between the inverter neutral branch and the grid neutral line within the target duration, control the other neutral relays except the target neutral relay among the at least one series-connected neutral relay to be closed, and adjust the output voltage of the voltage control circuit to change the potential magnitude of the bus neutral point relative to the ground.

In some embodiments, the bus neutral point of the inverter circuit is connected to the grid neutral point via at least one series-connected neutral relay. At least one resistance module is provided in the inverter circuit. The resistance module includes a first switch and at least one first resistor connected in series. The at least one resistance module is arranged between the ground and the target point. The target point includes the positive bus point, the bus neutral point, and the negative bus point of the inverter circuit.

The device may further include an eighth processing module configured to control the other neutral relays except the target neutral relay among the at least one series-connected neutral relay to be closed, and adjust the on-off state of the first switch to change the impedance magnitude of the bus neutral point relative to the ground.

The device for detecting the neutral relay in the embodiments of the present disclosure may be an electronic device, or a component in an electronic device, such as an integrated circuit or a chip. The electronic device may be a terminal or other device other than the terminal. For example, the electronic device may be a mobile phone, a tablet computer, a notebook computer, a handheld computer, a vehicle-mounted electronic device, a Mobile Internet Device (MID), augmented reality (AR)/virtual reality (VR) devices, a robot, a wearable device, an ultra-mobile personal computer (UMPC), a netbook or a personal digital assistant (PDA), etc., and may also be a server, a Network Attached Storage (NAS), a personal computer (PC), a television (TV), a teller machine, or a self-service machine, etc., which is not specifically limited in the embodiments of the present disclosure.

The device for detecting the neutral relay in the embodiments of the present disclosure may be a device having an operating system. The operating system may be an Android operating system, an IOS operating system, or other possible operating systems, which is not specifically limited in the embodiments of the present disclosure.

The device for detecting the neutral relay according to the embodiments of the present disclosure is capable of implementing various processes implemented in method embodiments of FIG. 9 to FIG. 15, which will not be described herein to avoid repetition.

The embodiments of the present disclosure further provide the inverter circuit.

As shown in FIG. 11, the inverter circuit includes a power conversion circuit, the bus capacitor, at least one phase branch, and the inverter neutral branch.

In this embodiment, the inverter circuit may include a single-phase inverter, a two-phase inverter, and a three-phase inverter, etc.

The bus capacitor is connected in parallel with the power conversion circuit.

At least one phase branch is arranged between the power conversion circuit and the power grid, and the phase branch is provided with at least one series-connected phase relay.

The inverter neutral branch is arranged between the power conversion circuit and the grid neutral line, and the inverter neutral branch is provided with at least one series-connected neutral relay.

The inverter circuit performs the sticking detection based on the method for detecting the neutral relay described in any of the embodiments above.

According to the inverter circuit provided by the embodiments of the present disclosure, when all phase relays arranged in the target phase branch are controlled to be closed and the other neutral relays except the target neutral relay among the series-connected neutral relay are controlled to be closed, whether the target neutral relay is stuck or not is detected based on the first voltage difference between the inverter neutral branch and the grid neutral line. The technical solution has a high detection precision and a high accuracy, and is simple and convenient to implement, and has a low detection cost.

In some embodiments, as shown in FIG. 17, the embodiments of the present disclosure further provide an electronic device 900. The electronic device 900 includes a processor 901, a memory 902, and a computer program stored in the memory 902 and executable on the processor 901. The processor 901, when executing the computer program, implements various processes of the embodiments of the method for detecting the neutral relay described above, and is capable of achieving the same technical results, which will not be described herein to avoid repetition.

It should be noted that the electronic device in the embodiments of the present disclosure includes a mobile electronic device and a non-mobile electronic device described above.

The embodiments of the present disclosure further provide a non-transitory computer-readable storage medium. The non-transitory computer-readable storage medium has a computer program stored thereon. A processor, when executing the computer program, implements various processes of the embodiments of the method for detecting the neutral relay described above, and is capable of achieving the same technical results, which will not be described herein to avoid repetition.

The processor is the processor in the electronic device described in the above embodiments. The readable storage medium includes a computer-readable storage medium, such as a computer read-only memory (ROM), a random access memory (RAM), a magnetic disk, or an optical disk.

The embodiments of the present disclosure further provide a computer program product including a computer program. A processor, when executing the computer program, implements the method for detecting the neutral relay described above.

The processor is the processor in the electronic device described in the above embodiments. The readable storage medium includes a computer-readable storage medium, such as a computer read-only memory (ROM), a random access memory (RAM), a magnetic disk, or an optical disk.

The embodiments of the present disclosure further provide a chip. The chip includes a processor and a communication interface. The communication interface is coupled with the processor, and the processor is configured to run programs or instructions to implement various processes of the embodiments of the method for detecting the neutral relay, and is capable of achieving the same technical results, which will not be described herein to avoid repetition.

It should be understood that the chip mentioned in the embodiments of the present disclosure may further be referred to as a system-level chip, a system chip, a chip system, or a system-on-chip chip.

It should be noted that in the present disclosure, terms "include", "have", and any variations thereof are intended to cover non-exclusive inclusions, such that a process, method, product, or device that includes a series of elements is not necessarily limited to those clearly listed elements, but may also include other elements that are not clearly listed or are inherent to the process, method, product, or device. Without further limitation, an element defined by the phrase "including a ..." does not preclude the presence of additional identical elements in the process, method, product, or device that includes the element. Further, it should be noted that the scope of methods and devices in the embodiments of the present disclosure is not limited to performing functions in an order shown or discussed, but may also include performing functions substantially simultaneously or in a reverse order depending on the functions involved, e.g., the described methods may be performed in an order different from that described, and various steps may be added, omitted, or combined. Additionally, features described with reference to certain examples may be combined in other examples.

From the above description of the implementations, it will be clear to those skilled in the art that the method of the above embodiments can be implemented with the aid of software and a necessary common hardware platform or can be implemented through hardware. In many cases, the former one is a better implementation. Based on this understanding, all or part of the technical solutions according to the embodiments of the present disclosure, or the part thereof that contributes to the related art, can be embodied in the form of a software product. The computer software product may be stored in a storage medium (such as a Read Only Memory (ROM)/Random Access Memory (RAM), a disk, and an optical disk) and contain instructions to enable a terminal device (which may be a mobile phone, a computer, a server, a network device, etc.) to perform the method described in each of the embodiments of the present disclosure.

The embodiments of the present disclosure are described above with reference to the accompanying drawings, but the present disclosure is not limited to the above specific implementations, which are merely illustrative, rather than restrictive. Under the motivation of the present disclosure, those skilled in the art can also make many variations without departing from the principles of the present disclosure and the protection scope of the claims as attached. These variations are to be encompassed by the protect scope of present disclosure.

In the description of this specification, description with reference to the terms "an embodiment", "some embodiments", "exemplary embodiments", "examples" "specific examples", or "some examples" etc., mean that specific features, structure, materials or characteristics described in conjunction with the embodiment or example are included in at least one embodiment or example of the present disclosure. In this specification, the schematic representations of the above terms do not necessarily refer to the same embodiment or example. Moreover, the described specific features, structures, materials or characteristics may be combined in any one or more embodiments or examples in a suitable manner.

Although embodiments of the present disclosure have been illustrated and described, it is conceivable for those of ordinary skill in the art that various changes, modifications, replacements, and variations can be made to these embodiments without departing from the principles of the present disclosure. The scope of the present disclosure shall be defined by the claims as appended and their equivalents.

## Claims

1. A method for detecting a neutral relay, the method being applied to an inverter circuit, the inverter circuit having a bus neutral point connected to a grid neutral point via at least one series-connected neutral relay, the method comprising:

    applying a voltage disturbance to the bus neutral point when other neutral relays except a target neutral relay among the at least one series-connected neutral relay are closed;
    acquiring potential change information of the bus neutral point relative to the grid neutral point within a period during which the voltage disturbance is applied; and
    determining a sticking state of the target neutral relay based on the potential change information and a target threshold.

2. The method for detecting the neutral relay according to claim 1, wherein said applying the voltage disturbance to the bus neutral point comprises:
changing a voltage difference between the bus neutral point and a negative bus of the inverter circuit.

3. The method for detecting the neutral relay according to claim 2, wherein said changing the voltage difference between the bus neutral point and the negative bus of the inverter circuit comprises:
adjusting a balancing bridge circuit in the inverter circuit to change the voltage difference between the bus neutral point and the negative bus of the inverter circuit.

4. The method for detecting the neutral relay according to claim 3, wherein said adjusting the balancing bridge circuit in the inverter circuit comprises:

    adjusting the voltage difference to a first value by adjusting the balancing bridge circuit in the inverter circuit at a first moment; and
    adjusting the voltage difference to a second value by adjusting the balancing bridge circuit in the inverter circuit at a second moment, the second moment being later than the first moment.

5. The method for detecting the neutral relay according to claim 4, wherein said acquiring the potential change information of the bus neutral point relative to the grid neutral point within the period during which the voltage disturbance is applied comprises:

    acquiring a first voltage of the bus neutral point relative to the grid neutral point subsequent to said adjusting the voltage difference to the first value;
    acquiring a second voltage of the bus neutral point relative to the grid neutral point subsequent to said adjusting the voltage difference to the second value; and
    determining the potential change information based on a difference between the first voltage and the second voltage.

6. The method for detecting the neutral relay according to claim 1, wherein said applying the voltage disturbance to the bus neutral point comprises:

    changing a potential magnitude of the bus neutral point relative to ground; or
    changing an impedance magnitude of the bus neutral point relative to the ground.

7. The method for detecting the neutral relay according to claim 6, wherein:

    when the inverter circuit is provided with a voltage control circuit having one end connected to the bus neutral point and another end grounded, said changing the potential magnitude of the bus neutral point relative to the ground comprises: adjusting an output voltage of the voltage control circuit to change the potential magnitude of the bus neutral point relative to the ground; when the inverter circuit is provided with at least one resistance module each comprising a first switch and at least one first resistor connected in series, and when the at least one resistance module is arranged between the ground and a target point comprising at least one of a positive bus point, the bus neutral point, and a negative bus point of the inverter circuit, said changing the impedance magnitude of the bus neutral point relative to the ground comprises: adjusting an on-off state of the first switch to change the impedance magnitude of the bus neutral point relative to the ground.

8. The method for detecting the neutral relay according to any one of claims 1 to 7, wherein said determining the sticking state of the target neutral relay based on the potential change information and the target threshold comprises:

   determining that the target neutral relay is not stuck when the potential change information is greater than the target threshold; and
   determining that the target neutral relay is stuck when the potential change information is smaller than or equal to the target threshold.

9. The method for detecting the neutral relay according to any one of claims 1 to 8, wherein said applying the voltage disturbance to the bus neutral point when the other neutral relays except the target neutral relay among the at least one series-connected neutral relay are closed comprises: applying the voltage disturbance to the bus neutral point when the inverter circuit is not grid-connected and when the other neutral relays except the target neutral relay among the at least one series-connected neutral relay are closed.

10. The method for detecting the neutral relay according to claim 1, wherein the inverter circuit comprises at least one phase branch and an inverter neutral branch, the at least one phase branch being provided with at least one series-connected phase relay, and the inverter neutral branch being provided with at least one series-connected neutral relay, and wherein the method further comprises:

    controlling all phase relays arranged in a target phase branch among the at least one phase branch to be closed, and controlling the other neutral relays except the target neutral relay among the at least one series-connected neutral relay to be closed;
    acquiring a first voltage difference between the inverter neutral branch and a grid neutral line within a target duration; and
    determining the sticking state of the target neutral relay based on the first voltage difference.

11. The method for detecting the neutral relay according to claim 10, wherein said controlling all the phase relays arranged in the target phase branch among the at least one phase branch to be closed, and controlling the other neutral relays except the target neutral relay among the at least one series-connected neutral relay to be closed comprises:

    controlling all the phase relays arranged in the target phase branch to be closed;
    adjusting a difference between an inverter output voltage of the inverter circuit and a grid voltage to be smaller than or equal to a first target threshold; and
    controlling the other neutral relays to be closed.

12. The method for detecting the neutral relay according to claim 11, wherein said acquiring the first voltage difference between the inverter neutral branch and the grid neutral line within the target duration comprises:

    controlling the inverter circuit to stop outputting voltage; and
    acquiring the first voltage difference between the inverter neutral branch and the grid neutral line within the target duration.

13. The method for detecting the neutral relay according to any one of claims 10 to 12, wherein said determining the sticking state of the target neutral relay based on the first voltage difference comprises:

    calculating a voltage difference effective value corresponding to the first voltage difference based on the first voltage difference; and
    determining the sticking state of the target neutral relay based on the voltage difference effective value and a second target threshold.

14. An inverter detection circuit based on the method for detecting the neutral relay according to any one of claims 1 to 13, the inverter detection circuit comprising:

    a voltage disturbance module connected to the inverter circuit and configured to apply the voltage disturbance to the bus neutral point of the inverter circuit; and

a processing module configured to determine the sticking state of the target neutral relay based on the potential change information of the bus neutral point relative to the grid neutral point.

15. The inverter detection circuit according to claim 14, wherein the voltage disturbance module comprises: a balancing bridge circuit connected between a positive bus and a negative bus of the inverter circuit, wherein the balancing bridge circuit comprises a first switching tube and a second switching tube connected in series, a point between the first switching tube and the second switching tube being connected to the bus neutral point via a first inductor.

Apply a voltage disturbance to the bus neutral point when other neutral relays except a target neutral relay among the at least one series-connected neutral relay are closed ⟍⟋ 110

Acquire potential change information of the bus neutral point relative to the grid neutral point within a period during which the voltage disturbance is applied ⟍⟋ 120

Determine a sticking state of the target neutral relay based on the potential change information and a target threshold ⟍⟋ 130

FIG. 1

FIG. 2

FIG. 3

FIG. 4

EP 4 624 950 A1

FIG. 5

FIG. 6

| First processing module ——1310 | Second processing module ——1320 | Third processing module ——1330 |

FIG. 7

——1400

**Electronic device**

| Processor ——1401 | ⟺ | Memory ——1402 |

FIG. 8

| Control all phase relays arranged in a target phase branch among the at least one phase branch to be closed, and control the other neutral relays except the target neutral relay among the at least one series-connected neutral relay to be closed | ⟿ 910 |

| Acquire a first voltage difference between the inverter neutral branch and a grid neutral line within a target duration | ⟿ 920 |

| Determine the sticking state of the target neutral relay based on the first voltage difference | ⟿ 930 |

FIG. 9

A relay 1  A relay 2

A phase

B relay 1  B relay 2

B phase

Inverter

C relay 1   C relay 2

C phase

Direct
current
voltage
input

$U_{inv}$

$U_{grid}$

Inverter  N relay 1  N relay 2    Grid N line
N line

$U_{delta}$

FIG. 10

FIG. 11

FIG. 12

FIG. 13

FIG. 14

FIG. 15

EP 4 624 950 A1

1610    1620    1630

| Fourth processing module | Fifth processing module | Sixth processing module |

FIG. 16

900

Electronic device

901                            902

| Processor | ⟺ | Memory |

FIG. 17

FIG. 18

FIG. 19

FIG. 20

FIG. 21

EP 4 624 950 A1

FIG. 22

FIG. 23

FIG. 24

A relay 1    A relay 2

A phase

$U_{inv}$    $U_{grid}$

Inverter

N relay 1    N relay 2

Inverter N line    Grid N line

$U_{delta}$

Direct current voltage input

FIG. 25

40

FIG. 26

EP 4 624 950 A1

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 113 238 146 B (SUNGROW POWER SUPPLY CO LTD) 24 May 2022 (2022-05-24) | 1,2, 8-11,14 | INV. G01R31/327 |
| A | * paragraph [0053] - paragraph [0104] * | 3-7,12, 13,15 | |
| A | EP 4 033 263 A1 (SOLAR POWER NETWORK TECH ZHEJIANG CO LTD [CN]) 27 July 2022 (2022-07-27) * paragraph [0019] - paragraph [0027]; claims 1-3 * | 1-15 | |
| A | EP 3 176 802 A1 (INGETEAM POWER TECH SA [ES]) 7 June 2017 (2017-06-07) * paragraph [0014] - paragraph [0037] * | 1-15 | |
| A | CN 108 761 319 B (SUNGROW POWER SUPPLY CO LTD) 28 August 2020 (2020-08-28) * paragraph [0055] - paragraph [0093] * | 1-15 | |

**TECHNICAL FIELDS SEARCHED (IPC)**

G01R

The present search report has been drawn up for all claims

| Place of search | Date of completion of the search | Examiner |
|---|---|---|
| Munich | 20 August 2025 | Meggyesi, Zoltán |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 16 6150

This annex lists the patent family members relating to the patent documents cited in  the above-mentioned European search report.
The members are as contained in the European Patent Office EDP file on
The European Patent Office is in no way liable for these particulars which are merely given for the purpose of information.

20-08-2025

| Patent document cited in search report | | Publication date | Patent family member(s) | | Publication date |
|---|---|---|---|---|---|
| CN 113238146 | B | 24-05-2022 | NONE | | |
| EP 4033263 | A1 | 27-07-2022 | CN | 112415377 A | 26-02-2021 |
| | | | EP | 4033263 A1 | 27-07-2022 |
| | | | WO | 2022156124 A1 | 28-07-2022 |
| EP 3176802 | A1 | 07-06-2017 | EP | 3176802 A1 | 07-06-2017 |
| | | | ES | 2668298 T3 | 17-05-2018 |
| | | | US | 2017264212 A1 | 14-09-2017 |
| | | | WO | 2016016479 A1 | 04-02-2016 |
| CN 108761319 | B | 28-08-2020 | NONE | | |

EPO FORM P0459

For more details about this annex : see Official Journal of the European Patent Office, No. 12/82

**REFERENCES CITED IN THE DESCRIPTION**

**Patent documents cited in the description**

- CN 202410348582
- CN 202410490931